(19) Europäisches Patentamt
European Patent Office
Office européen des brevets

(11) EP 4 786 634 A1

(12) **EUROPEAN PATENT APPLICATION**

(43) Date of publication:
05.08.2026 Bulletin 2026/32

(21) Application number: 25223699.7

(22) Date of filing: 16.12.2025

(51) International Patent Classification (IPC):
$C23C \ 16/455^{(2006.01)}$    $H10P \ 14/60^{(2026.01)}$

(52) Cooperative Patent Classification (CPC):
C23C 16/45523; C23C 16/45527; C23C 16/45534;
H10P 14/6339

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 29.01.2025 JP 2025013308

(71) Applicant: Kokusai Electric Corporation
Tokyo 101-0045 (JP)

(72) Inventor: SANO, Atsushi
Toyama-shi, Toyama, 939-2393 (JP)

(74) Representative: Bardehle Pagenberg
Partnerschaft mbB
Patentanwälte Rechtsanwälte
Prinzregentenplatz 7
81675 München (DE)

(54) **METHOD OF PROCESSING SUBSTRATE, METHOD OF MANUFACTURING SEMICONDUCTOR DEVICE, SUBSTRATE PROCESSING APPARATUS, AND PROGRAM**

(57) There is provided a technique that includes (a) forming a layer containing a first element on a substrate by performing: (a1) supplying an inhibiting gas to the substrate to form an inhibiting group on the substrate, wherein the inhibiting group inhibits adsorption of a first gas containing an atom of the first element to the substrate; (a2) supplying a promoting gas to the substrate after start of (a1) to form a promoting group on the substrate, wherein the promoting group promotes adsorption of the first gas to the substrate; and (a3) supplying the first gas to the substrate after start of (a2).

## FIG. 3G

EP 4 786 634 A1

**Description**

CROSS-REFERENCE TO RELATED APPLICATION

This application is based upon and claims the benefit of priority from Japanese Patent Application No. 2025-013308, filed on January 29, 2025, the entire contents of which are incorporated herein by reference.

Field

The present disclosure relates to a method of processing a substrate, a method of manufacturing a semiconductor device, a substrate processing apparatus, and a program.

Description of the Related Art

As one step of a semiconductor device manufacturing process or a substrate processing process, a layer to which a small amount of a predetermined element is added may be formed on a substrate.

Summary

The present disclosure provides a technique capable of forming a homogeneous layer (or film) on a substrate.
According to an embodiment of the present disclosure, provided is a technique including

(a) forming a layer containing a first element on a substrate by performing:

(a1) supplying an inhibiting gas to the substrate to form an inhibiting group on the substrate, wherein the inhibiting group inhibits adsorption of a first gas containing an atom of the first element to the substrate;
(a2) supplying a promoting gas to the substrate after start of (a1) to form a promoting group on the substrate, wherein the promoting group promotes adsorption of the first gas to the substrate; and
(a3) supplying the first gas to the substrate after start of (a2).

Brief Description of the Drawings

FIG. 1 is a schematic configuration view of a vertical processing furnace of a substrate processing apparatus, and is a longitudinal cross-sectional view of a processing furnace portion.
FIG. 2 is a schematic configuration diagram of a controller of the substrate processing apparatus, and is a block diagram of a control system of the controller.

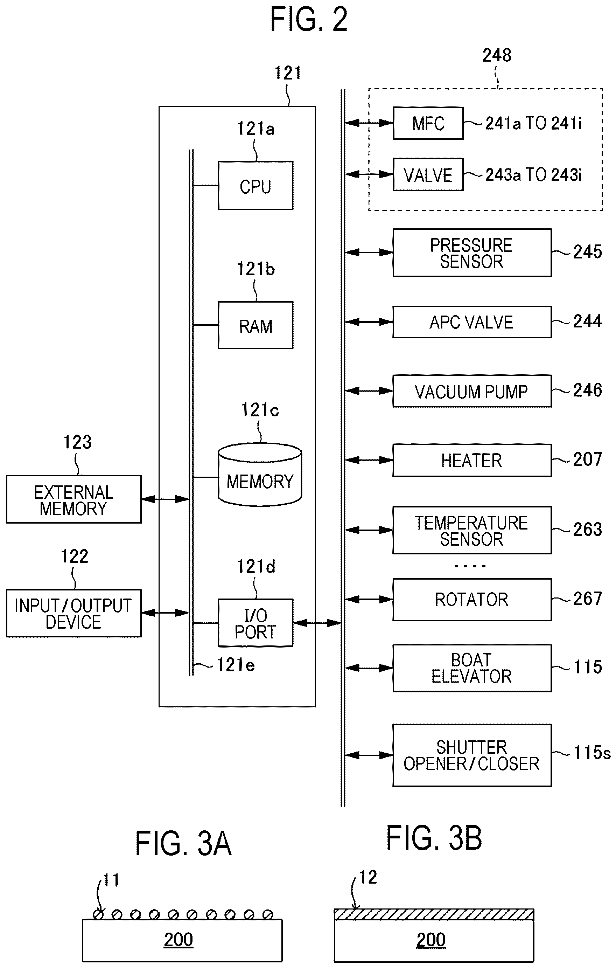

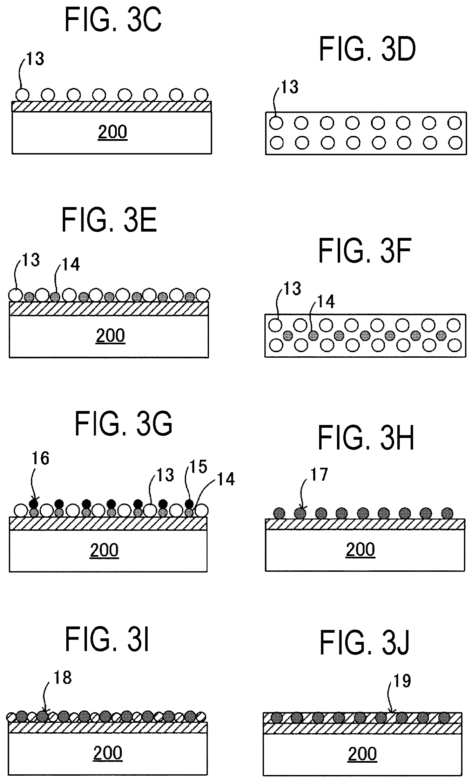

FIG. 3A is a partially enlarged cross-sectional view of a surface of a wafer after supply of a second gas. FIG. 3B is a partially enlarged cross-sectional view of the surface of the wafer after supply of a reactant gas. FIG. 3C is a partially enlarged cross-sectional view of the surface of the wafer after supply of an inhibiting gas. FIG. 3D is an image diagram of FIG. 3C as viewed from above. FIG. 3E is a partially enlarged cross-sectional view of the surface of the wafer after supply of a promoting gas. FIG. 3F is an image diagram of FIG. 3E as viewed from above. FIG. 3G is a partially enlarged cross-sectional view of the surface of the wafer after supply of a first gas. FIG. 3H is a partially enlarged cross-sectional view of the surface of the wafer after supply of a removal gas. FIG. 3I is a partially enlarged cross-sectional view of the surface of the wafer after supply of a second gas. FIG. 3J is a partially enlarged cross-sectional view of the surface of the wafer after supply of the reactant gas.
FIG. 4A is a partially enlarged cross-sectional view of a recess of the wafer after supply of the inhibiting gas and the promoting gas. FIG. 4B is a partially enlarged cross-sectional view of the recess of the wafer after supply of the first gas.
FIG. 4C is a partially enlarged cross-sectional view of the recess of the wafer after supply of the removal gas, supply of the second gas, and supply of the reactant gas.

Detailed Description

<Embodiment of present disclosure>

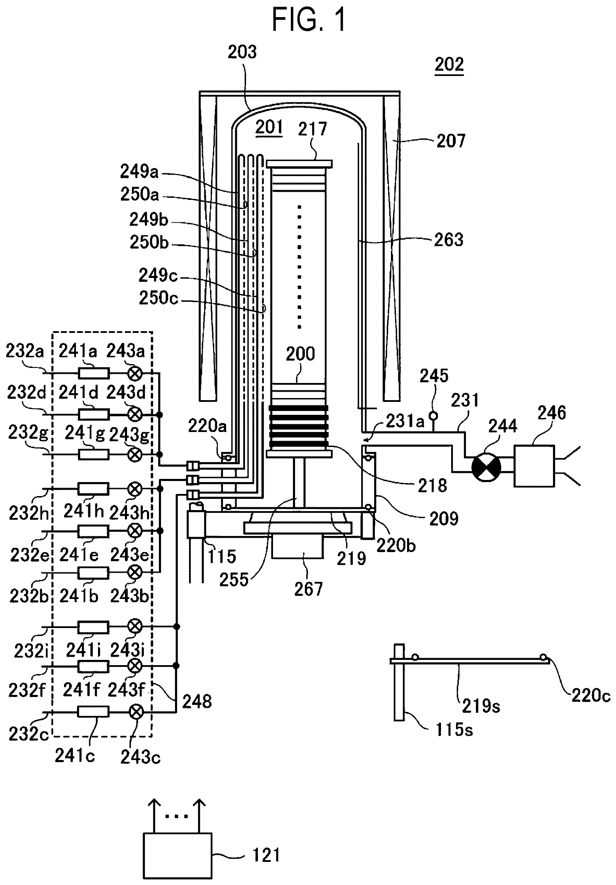

An embodiment of the present disclosure will be described below mainly with reference to FIGS. 1 to 4C. Note that the drawings used in the following description are all schematic, and a dimensional relationship among elements, a ratio among the elements, and the like illustrated in the drawings do not necessarily coincide with actual ones. In addition, a dimensional relationship among elements, a ratio among the elements, and the like do not necessarily coincide among a plurality of drawings.

(1) Configuration of substrate processing apparatus

As illustrated in FIG. 1, a processing furnace 202 includes a heater 207 serving as a temperature regulator (heater). The heater 207 also functions as an activator (exciter) that thermally activates (excites) a gas. Inside the heater 207, a reaction tube 203 is disposed. A manifold 209 is disposed below the reaction tube 203, and an O-ring 220a serving as a seal member is provided between the manifold 209 and the reaction tube 203. A process container (reaction container) is constituted mainly by the reaction tube 203 and the manifold 209. A process chamber 201 is formed inside the process container.

In the process chamber 201, nozzles 249a to 249c serving as first to third suppliers are provided, respectively. The nozzles 249a to 249c are also referred to as first to third nozzles, respectively. To the nozzles 249a to 249c, gas supply pipes 232a to 232c are connected, respectively. The nozzles 249a to 249c have gas supply holes 250a to 250c through which a gas is supplied toward the wafer 200, respectively. A plurality of the gas supply holes 250a, a plurality of the gas supply holes 250b, and a plurality of the gas supply holes 250c are formed from lower portions to upper portions of the nozzles 249a to 249c, respectively.

In the gas supply pipes 232a to 232c, mass flow controllers (MFCs) 241a to 241c that are flow rate controllers and valves 243a to 243c that are opening/closing valves are provided, respectively, in this order from an upstream side of a gas flow. Gas supply pipes 232d and 232g are connected to the gas supply pipe 232a on a downstream side of the valve 243a. Gas supply pipes 232e and 232h are connected to the gas supply pipe 232b on a downstream side of the valve 243b. Gas supply pipes 232f and 232i are connected to the gas supply pipe 232c on a downstream side of the valve 243c. In the gas supply pipes 232d to 232i, MFCs 241d to 241i and valves 243d to 243i are provided, respectively, in this order from an upstream side of a gas flow.

A first gas is supplied into the process chamber 201 via the gas supply pipe 232a, the MFC 241a, the valve 243a, and the nozzle 249a. The first gas is a gas containing an atom of a first element. A second gas is supplied into the process chamber 201 via the gas supply pipe 232b, the MFC 241b, the valve 243b, and the nozzle 249b. The second gas is a gas containing an atom of a second element different from the first element. A reactant gas is supplied into the process chamber 201 via the gas supply pipe 232c, the MFC 241c, the valve 243c, and the nozzle 249c. An inhibiting gas is supplied into the process chamber 201 via the gas supply pipe 232d, the MFC 241d, the valve 243d, the gas supply pipe 232a, and the nozzle 249a. The inhibiting gas is a gas that forms, on the wafer 200, an inhibiting group that inhibits adsorption of the first gas onto the wafer 200. A promoting gas is supplied into the process chamber 201 via the gas supply pipe 232e, the MFC 241e, the valve 243e, the gas supply pipe 232b, and the nozzle 249b. The promoting gas is a gas that forms, on the wafer 200, a promoting group that promotes adsorption of the first gas onto the wafer 200. A removal gas is supplied into the process chamber 201 via the gas supply pipe 232f, the MFC 241f, the valve 243f, the gas supply pipe 232c, and the nozzle 249c.

The removal gas is a gas that removes at least some of the inhibiting groups on the wafer 200.

Inert gases are supplied into the process chamber 201 via the gas supply pipes 232g to 232i, the MFCs 241g to 241i, the valves 243g to 243i, the gas supply pipes 232a to 232c, and the nozzles 249a to 249c, respectively. The inert gas acts as a purge gas, a carrier gas, a diluent gas, or the like.

Mainly, the gas supply pipe 232a, the MFC 241a, and the valve 243a constitute a first gas supply system. Mainly, the gas supply pipe 232b, the MFC 241b, and the valve 243b constitute a second gas supply system. Mainly, the gas supply pipe 232c, the MFC 241c, and the valve 243c constitute a reactant gas supply system. Mainly, the gas supply pipe 232d, the MFC 241d, and the valve 243d constitute an inhibiting gas supply system. Mainly, the gas supply pipe 232e, the MFC 241e, and the valve 243e constitute a promoting gas supply system. Mainly, the gas supply pipe 232f, the MFC 241f, and the valve 243f constitute a removal gas supply system. Mainly, the gas supply pipes 232g to 232i, the MFCs 241g to 241i, and the valves 243g to 243i constitute an inert gas supply system. All or at least one of the above-described various supply systems constitutes a gas supply system. Nozzles connected to gas supply pipes constituting the above-described various supply systems may be included in the supply systems, respectively.

In a lower portion of a side wall of the reaction tube 203, an exhaust port 231a to which an exhaust pipe 231 is connected and from which an atmosphere in the process chamber 201 is discharged is formed. To the exhaust pipe 231, a vacuum pump 246 serving as a vacuum-exhauster is connected via a pressure sensor 245 serving as a pressure detector that detects a pressure in the process chamber 201 and an auto pressure controller (APC) valve 244 serving as a pressure regulator. The APC valve 244 can perform vacuum exhaust and vacuum exhaust stop in the process chamber 201 by being opened and closed while the vacuum pump 246 is operated. The APC valve 244 can regulate a pressure in the process chamber 201 by adjusting a degree of valve opening on the basis of pressure information detected by the pressure sensor 245 while the vacuum pump 246 is operated. Mainly, the exhaust pipe 231, the APC valve 244, and the pressure sensor 245 constitute an exhaust system. The vacuum pump 246 may be included in the exhaust system.

Below the manifold 209, a seal cap 219 that can airtightly close a lower end opening of the manifold 209 is provided. On an upper surface of the seal cap 219, an O-ring 220b serving as a seal member in contact with a lower end of the manifold 209 is provided. Below the seal cap 219, a rotator 267 that is connected to a boat 217 via a rotation shaft 255 and rotates the boat 217 and the wafers 200 is disposed. A boat elevator 115 (lifter) is configured as a transferrer that lifts the seal cap 219 up and down, thereby loading/unloading (transferring) the wafer 200 into/from the process chamber 201.

Below the manifold 209, a shutter 219s capable of airtightly closing the lower end opening of the manifold 209 in a state where the seal cap 219 is lowered and the boat 217 is unloaded from the inside of the process chamber 201 is provided. On an upper surface of the shutter 219s, an O-ring 220c serving as a seal member in contact with a lower end of the manifold 209 is provided. An opening/closing operation (lifting operation, rotating operation, and the like) of the shutter 219s is controlled by a shutter opener/closer 115s.

The boat 217 serving as a substrate supporter is configured to support, for example, 25 to 200 wafers 200 in multiple stages in a horizontal posture. Note that the notation of a numerical range such as "25 to 200" in the present specification means that a lower limit value and an upper limit value are included in the range. Therefore, for example, "25 to 200" means "25 or more and 200 or less." The same applies to other numerical ranges. In a lower portion of the boat 217, heat insulating plates 218 made of a heat-resistant material such as quartz or SiC are supported in multiple stages.

In the reaction tube 203, a temperature sensor 263 serving as a temperature detector is disposed. By regulating power supplied to the heater 207 on the basis of temperature information detected by the temperature sensor 263, a temperature in the process chamber 201 or a temperature of the wafer 200 can have a desired temperature distribution. The temperature sensor 263 is provided along an inner wall of the reaction tube 203.

As illustrated in FIG. 2, the controller 121, which is a controller, is configured as a computer including a central processing unit (CPU) 121a, random access memory (RAM) 121b, a memory 121c, and an I/O port 121d. The RAM 121b, the memory 121c, and the I/O port 121d are configured to be able to exchange data with the CPU 121a via an internal bus 121e. To the controller 121, an input/output device 122 configured as, for example, a touch panel is connected. In addition, to the controller 121, an external memory 123 can be connected. Note that the substrate processing apparatus may include a single controller or may include a plurality of controllers. That is, control for a processing sequence described later may be performed with a single controller or with a plurality of controllers. In addition, a plurality of controllers may be configured as a control system in which the controllers are mutually connected by a wired or wireless communication network, and control for performing the processing sequence described later may be performed by the entire control system. In the present specification, the term "controller" may include one controller, may include a plurality of controllers, or may include a control system including a plurality of controllers.

The memory 121c includes, for example, a flash memory, a hard disk drive (HDD), and a solid state drive (SSD). In the memory 121c, a control program that controls operation of the substrate processing apparatus, a process recipe in which procedures, conditions, and the like of substrate processing described later are described, and the like are readably recorded and stored. The process recipe is a combination formed such that the controller 121 causes the substrate processing apparatus to execute each procedure in substrate processing described later to obtain a predetermined result, and functions as a program. Hereinafter, the process recipe, the control program and the like are collectively and simply referred to as a program (program product). The process recipe is simply referred to as a recipe. In the present specification, the term "program" may include only a recipe alone, may include only a control program alone, or may include both of them. The RAM 121b is configured as a memory area (work area) in which a program, data, and the like read by the CPU 121a are temporarily stored.

The I/O port 121d is connected to the MFCs 241a to 241i, the valves 243a to 243i, the pressure sensor 245, the APC valve 244, the vacuum pump 246, the temperature sensor 263, the heater 207, the rotator 267, the boat elevator 115, the shutter opener/closer 115s, and the like described above.

The CPU 121a is configured to be able to read and execute a control program from the memory 121c, and to read a recipe from the memory 121c in response to an input and the like of an operation command from the input/output device 122. The CPU 121a is configured to be able to control, in accordance with a content of a read recipe, a flow rate regulating operation of various substances (various gases) by the MFCs 241a to 241i, an opening/closing operation of the valves 243a to 243i, a pressure regulating operation by the APC valve 244 based on an opening/closing operation of the APC valve 244 and the pressure sensor 245, start and stop of the vacuum pump 246, a temperature regulating operation of the heater 207 based on the temperature sensor 263, rotation and rotating speed regulating operation of the boat 217 by the rotator 267, a lifting operation of the boat 217 by the boat elevator 115, an opening/closing operation of the shutter 219s by the shutter opener/closer 115s, and the like.

The controller 121 can be configured by installing the above-described program recorded and stored in the external memory 123 into a computer. Examples of the external memory 123 include a magnetic disk such as an HDD, an optical disk such as a CD, a magneto-optical disk such as an MO, and a semiconductor memory such as a USB memory or an SSD. The memory 121c and the external memory 123 are configured as computer-readable recording media.

Hereinafter, these are collectively and simply referred to as recording media. In the present specification, the term "recording medium" may include only the memory 121c alone, may include only the external memory 123 alone, or may include both of them. Note that, the program may be provided to the computer by using a communication means such as the Internet or a dedicated line without using the external memory 123.

(2) Substrate processing process

As one step of a semiconductor device manufacturing process using the substrate processing apparatus described above, a method of processing a substrate, that is, a processing sequence example of forming a layer containing a first element and a second element to which a small amount of the first element is added (doped) on the wafer 200 will be described mainly with reference to FIGS. 3A to 3J. In the following description, an operation of each unit constituting the substrate processing apparatus is controlled by the controller 121.

A processing sequence in the present embodiment includes,

(a) forming a layer containing the first element on the wafer 200 by performing:

(a1) supplying an inhibiting gas to the wafer 200 to form an inhibiting group on the wafer 200, wherein the inhibiting group inhibits adsorption of a first gas containing an atom of the first element to the wafer 200;
(a2) supplying a promoting gas to the wafer 200 after start of (a1) to form a promoting group on the wafer 200, wherein the promoting group promotes adsorption of the first gas to the wafer 200; and
(a3) supplying the first gas to the wafer 200 after start of (a2).

The processing sequence further includes, the step (a) includes, (a4) a step of supplying a removal gas to the wafer 200 after start of (a3) to remove at least some of the inhibiting groups on the wafer 200.

The processing sequence further includes,
(b) forming a layer containing the first element and the second element by performing a cycle a predetermined number of times, wherein the cycle including:

(b1) supplying a second gas containing an atom of the second element different from the first element to the wafer 200; and
(b2) supplying a reactant gas to the wafer 200.

In the present embodiment, a case where the step b of performing a first cycle including (b1) and (b2) a predetermined number of times (m times, m is 1 or an integer of 2 or more) and the step a of performing a second cycle including (a1), (a2), (a3), and (a4) a predetermined number of times (n times, n is 1 or an integer of 2 or more) are performed a predetermined number of times (p times, p is 1 or an integer of 2 or more) will be described.

In the present specification, the above-described processing sequence may be expressed as follows for convenience.

$$[(\text{second gas} \rightarrow \text{reactant gas} \rightarrow) \times m \rightarrow (\text{inhibiting gas} \rightarrow \text{promoting gas} \rightarrow \text{first gas} \rightarrow \text{removal gas} \rightarrow) \times_n] \times p$$

In the present specification, the above "→" indicates that a purge process of purging the inside of the process chamber 201 is performed.

The term "wafer" used in the present specification may mean a wafer itself, or a stack of the wafer and a predetermined layer or film formed on a surface thereof. The term "surface of the wafer" used in the present specification may mean a surface of the wafer itself or a surface of a predetermined layer or the like formed on the wafer. The phrase "forming a predetermined layer on the wafer" in the present specification may mean that a predetermined layer is directly formed on a surface of the wafer itself or that a predetermined layer is formed on a layer or the like formed on the wafer. In the present specification, the term "substrate" is synonymous with the term "wafer".

The term "layer" used in the present specification includes at least one of a continuous layer and a discontinuous layer. For example, a deposition layer may include a continuous layer, may include a discontinuous layer, or may include both of them.

In the present specification, in a case where adsorption of each gas to a surface of the wafer 200 or reaction of each gas with the surface of the wafer 200 is described, not only an embodiment in which each gas is adsorbed to or reacts with the surface of the wafer 200 in an undecomposed state, but also an embodiment in which an intermediate generated by decomposition of each gas or desorption of a ligand thereof is adsorbed to or reacts with the surface of the wafer 200 may be included.

(Wafer Charge and Boat Load)

A plurality of wafers 200 are charged into the boat 217 (wafer charge). The shutter 219s is moved by the shutter opener/closer 115s to open a lower end opening of the manifold 209 (shutter open). Thereafter, the boat 217 that supports the plurality of wafers 200 is raised by the boat elevator 115 and is loaded into the process chamber 201 (boat load). In this state, the seal cap 219 seals a lower end of the manifold 209 via the O-ring 220b. In this manner, as illustrated in FIG. 1, the wafers 200 are prepared (provided) in the process chamber 201.

(Pressure Regulation and Temperature Regulation)

After the boat load is finished, the inside of the process chamber 201, that is, a space in which the wafers 200 are present is vacuum-exhausted (decompression-exhausted) by the vacuum pump 246 so as to achieve a desired pressure (vacuum degree). At that time, a pressure in the process chamber 201 is measured by the pressure sensor 245, and the APC valve 244 is feedback-controlled on the basis of information of the measured pressure. In addition, the wafers 200 in the process chamber 201 are heated by the heater 207 so as to have a desired processing temperature. At this time, on the basis of temperature information detected by the temperature sensor 263, power supplied to the heater 207 is feedback-controlled in such a manner that a desired temperature distribution is obtained in the process chamber 201. In addition, the rotator 267 starts rotating the wafers 200. Both the exhaust of the inside of the process chamber 201 and the heating and rotation of the wafers 200 are continuously performed at least until processing on the wafers 200 ends.

(Film Forming Processing)

(Step b)

First, the following steps b1 and b2 are sequentially executed on the wafers 200.

[Step b1]

In this step, the second gas is supplied to the wafers 200 in the process chamber 201. Specifically, the valve 243b is opened to cause the second gas to flow into the gas supply pipe 232b. A flow rate of the second gas is regulated by the MFC 241b, and the second gas is supplied into the process chamber 201 and to the wafers 200 via the nozzle 249b and exhausted from the exhaust port 231a (second gas supply). At this time, the valves 243g to 243i may be opened to supply an inert gas into the process chamber 201 via the nozzles 249a to 249c, respectively.

Processing conditions when the second gas is supplied in this step are exemplified as follows:

processing temperature: 350 to 900°C, preferably 500 to 800°C,
processing pressure: 1 to 10,000 Pa, preferably 10 to 1,333 Pa,
second gas supply flow rate: 0.01 to 3 slm, preferably 0.1 to 2 slm,
second gas supply time: 10 to 120 seconds, preferably 20 to 60 seconds, and
inert gas supply flow rate (for each gas supply pipe): 0 to 10 slm. Note that, in the following description, a processing temperature and an inert gas supply flow rate in each step of film forming processing are similar to those in this step.

Note that the processing temperature in the present specification means a temperature of the wafer 200 or a temperature in the process chamber 201, and the processing pressure means a pressure in the process chamber 201. A processing time means a time during which the processing is continued. The supply flow rate means a flow rate of a gas supplied into the process chamber 201. In a case where 0 slm is included in the supply flow rate, 0 slm means a case where the substance (gas) is not supplied into the process chamber 201. The same applies to the following description.

By this step, a first layer 11 can be formed by causing at least a part of the second gas to be physically or chemically adsorbed to the surface of the wafer 200 (see FIG. 3A). Specifically, as a result, the first layer 11 can be discontinuously formed on at least a part of the surface of the wafer 200 by causing at least a part of the second gas to be physically or chemically adsorbed thereto. More specifically, as a result, the first layer 11 can be discontinuously formed on the entire surface of the wafer 200 by causing at least a part of the second gas to be physically or chemically adsorbed thereto.

As the second gas, for example, a silane-based gas containing silicon (Si) serving as the second element can be used. As the silane-based gas, for example, a gas containing Si and halogen, that is, a halosilane-based gas can be used. The halogen includes chlorine (Cl), fluorine (F), bromine (Br), iodine (I), and the like. That is, the halosilane-based gas has at least one of halogen groups such as a chloro (Cl) group, a fluoro (F) group, a bromo (Br) group, and an iodo (I) group as a functional group.

As the second gas, for example, a chlorosilane-based gas such as a monochlorosilane ($SiH_3Cl$) gas, a dichlorosilane ($SiH_2Cl_2$) gas, a trichlorosilane ($SiHCl_3$) gas, a tetrachlorosilane ($SiCl_4$) gas, a hexachlorodisilane ($Si_2Cl_6$) gas, or an octachlorotrisilane ($Si_3Cl_8$) gas, a fluorosilane-based gas such as a tetrafluorosilane ($SiF_4$) gas, trifluorosilane ($SiHF_3$) gas, or a difluorosilane ($SiH_2F_2$) gas, a bromosilane-based gas such as a tetrabromosilane ($SiBr_4$) gas, a tribromosilane ($SiHBr_3$) gas, or a dibromosilane ($SiH_2Br_2$) gas, and an iodosilane-based gas such as a tetraiodosilane ($SiI_4$) gas, a triiodosilane ($SiHI_3$) gas, or a diiodosilane ($SiH_2I_2$) gas can also be used. As the second gas, one or more of these gases can be used.

In addition, as the second gas, for example, a gas containing Si serving as the second element and an organic ligand can be used. As the gas containing Si and an organic ligand, for example, an aminosilane-based gas such as a tetrakis(dimethylamino)silane ($Si[N(CH_3)_2]_4$) gas, a tris(dimethylamino)silane ($Si[N(CH_3)_2]_3H$) gas, a bis(diethylamino) silane ($Si[N(C_2H_5)_2]_2H_2$) gas, a bis(tertiarybutylamino)silane ($SiH_2[NH(C_4H_9)]_2$) gas, or a (diisopropylamino)silane ($SiH_3[N(C_3H_7)_2]$) gas can also be used. In addition, as the second gas, for example, a gas containing Si serving as the second element and a hydrogen (H) group can be used. As the gas containing Si and an H group, for example, monosilane ($SiH_4$) and disilane ($Si_2H_6$) can be used, and as the second gas, one or more of these gases can be used.

As the second gas, in addition to these gases, for example, a gas containing Si and an alkyl group serving as an organic ligand, that is, an alkylsilane-based gas can also be used. The alkyl group may be linear or branched. Examples of the alkyl group include a methyl group, an ethyl group, a n-propyl group, a n-butyl group, an isopropyl group, an isobutyl group, a sec-butyl group, and a tert-butyl group. As the second gas, one or more of these gases can be used.

As the second element, for example, one or more of tungsten (W), titanium (Ti), molybdenum (Mo), tantalum (Ta), cobalt (Co), yttrium (Y), ruthenium (Ru), hafnium (Hf), zirconium (Zr), aluminum (Al), boron (B), gallium (Ga), indium (In), phosphorus (P), carbon (C), and the like can be used.

As the second gas, for example, a gas containing the second element and a halogen element can be used. Examples of such a gas include hexachlorotungstate ($WCl_6$), hexafluorotungstate ($WF_6$), titanium tetrachloride ($TiCl_4$), titanium tetrafluoride ($TiF_4$), molybdenum pentachloride ($MoCl_5$), molybdenum pentafluoride ($MoF_5$), molybdenum dichloride dioxide ($MoO_2Cl_2$), molybdenum tetrachloride oxide ($MoOCl_4$), tantalum pentachloride ($TaCl_5$), tantalum pentafluoride ($TaF_5$), cobalt difluoride ($CoF_2$), cobalt dichloride ($CoCl_2$), yttrium trifluoride ($YF_3$), yttrium trichloride ($YCl_3$), ruthenium trichloride ($RuCl_3$), ruthenium trifluoride ($RuF_3$), hafnium tetrachloride ($HfCl_4$), hafnium tetrafluoride ($HfF_4$), zirconium tetrachloride ($ZrCl_4$), zirconium tetrafluoride ($ZrF_4$), aluminum trichloride ($AlCl_3$), and aluminum trifluoride ($AlF_3$). Examples of the second gas include boron trifluoride ($BF_3$), boron trichloride ($BCl_3$), gallium trifluoride ($GaF_3$), gallium trichloride ($GaCl_3$), indium trifluoride ($InF_3$), indium trichloride ($InCl_3$), phosphorus trifluoride ($PF_3$), phosphorus pentafluoride ($PF_5$), phosphorus trichloride ($PCl_3$), phosphorus pentachloride ($PCl_3$), carbon tetrafluoride ($CF_4$), carbon tetrachloride ($CCl_4$), trifluoromethane ($CHF_3$), fluoromethane ($CH_3F$), trichloromethane ($CHCl_3$), and chloromethane ($CH_3Cl$). As the second gas, for example, a gas containing the second element and a Br group, or a gas containing the second element and an I group can also be used. As the second gas, one or more of these gases can be used.

In addition, as the second gas, for example, a gas containing the second element and an organic ligand, or a gas containing the second element and a hydrogen group can be used. As the organic ligand, for example, an alkyl group, a cycloalkyl group, an alkoxide group, a phenyl group, and a cyclopentadienyl group can be used. Examples of the second gas include hexadimethylamino ditungsten ($W_2[N(CH_3)_2]_6$), bistertiarybutylimidebisdimethylamide tungsten (($t$-$C_4H_9NH)_2W=(Nt$-$C_4H_9)_2$), tetrakisethylmethylamino titanium ($Ti[N(C_2H_5)(CH_3)]_4$), bisethylcyclopentadienyl ruthenium ($Ru(CH_2CH_3)Cp)_2$), biscyclopentadienyl ruthenium ($Ru(Cp)_2$), tetrakisethylmethylamino hafnium ($Hf[N(CH_3)(CH_2CH_3)]_4$), tetrakisdiethylamino hafnium ($Hf[N(CH_2CH_3)_2]_4$), tetrakisdimethylamino hafnium ($Hf[N(CH_3)_2]_4$), trisdimethylaminocyclopentadienyl hafnium (($Cp)Hf[N(CH_3)_2]_3$), tetrakisethylmethylamino zirconium ($Zr[N(CH_3)Cp]_4$), tetrakisdiethylamino zirconium ($Zr[N(CH_2CH_3)_2]_4$), tetrakisdimethylamino zirconium ($Zr[N(CH_3)_2]_4$), trisdimethylaminocyclopentadienyl zirconium (($Cp)Zr[N(CH_3)_2]_3$), trimethylaluminum ($Al(CH_3)_3$), boron ($BH_3$), trimethylgallium ($Ga(CH_3)_3$), trimethylindium ($In(CH_3)_3$), phosphine ($PH_3$), and methane ($CH_4$). As the second gas, one or more of these gases can be used.

As the inert gas, a nitrogen ($N_2$) gas, or a rare gas such as an argon (Ar) gas, a helium (He) gas, a neon (Ne) gas, or a xenon (Xe) gas can be used. As the inert gas, one or more of these gases can be used. The same applies to each step described later.

After the first layer 11 is formed on the surface of the wafer 200, the valve 243b is closed to stop supply of the second gas into the process chamber 201. Then, the inside of the process chamber 201 is vacuum-exhausted to remove a gaseous substance and the like remaining in the process chamber 201 from the inside of the process chamber 201. At this time, the valves 243g to 243i are opened to supply an inert gas into the process chamber 201 via the nozzles 249a to 249c. The inert gas supplied from the nozzles 249a to 249c acts as a purge gas, and as a result, a space in which the wafers 200 are present, that is, the inside of the process chamber 201 is purged (purge).

[Step b2]

After start of the step b1, a reactant gas is supplied to the wafer 200 on a surface of which the first layer 11 is formed in the process chamber 201. Specifically, the valve 243c is opened to cause the reactant gas to flow into the gas supply pipe 232c. A flow rate of the reactant gas is regulated by the MFC 241c, and the reactant gas is supplied into the process chamber 201 and to the wafers 200 via the nozzle 249c and exhausted from the exhaust port 231a (reactant gas supply). At this time, the valves 243g to 243i may be opened to supply an inert gas into the process chamber 201 via the nozzles 249a to 249c, respectively.

Processing conditions when the reactant gas is supplied in this step are exemplified as follows:

processing pressure: 1 to 10,000 Pa, preferably, 10 to 1,333 Pa,
reactant gas supply flow rate: 1 to 30 slm, preferably, 2 to 20 slm, and
reactant gas supply time: 1 to 120 seconds, preferably, 1 to 60 seconds.

By this step, at least a part of the first layer 11 formed on the surface of the wafer 200 reacts with the reactant gas to be modified. As a result, a modified layer of the first layer 11 (hereinafter, also referred to as a second layer 12) is formed on the surface of the wafer 200 (see FIG. 3B). When the second layer 12 is formed, the reactant gas preferably removes (desorbs) at least some of functional groups formed on the wafer 200 in the step b1 from the first layer 11 by a chemical reaction. The removed functional groups are discharged from the inside of the process chamber 201. As a result, the second layer 12 becomes a layer having less impurities than the first layer 11 formed in the step b1.

As the reactant gas, for example, a gas containing a reducing gas, an oxidizing gas, a nitriding gas, a sulfurizing gas, a selenizing gas, a tellurizing gas, or the like can be used. As the reactant gas, one or more of these gases can be used.

As the reducing gas, for example, one or more of gases including a hydrogen ($H_2$) gas, a deuterium ($D_2$) gas, a borane ($BH_3$) gas, a diborane ($B_2H_6$) gas, a carbon monoxide (CO) gas, an ammonia ($NH_3$) gas, a monosilane ($SiH_4$) gas, a disilane ($Si_2H_6$) gas, a trisilane ($Si_3H_8$) gas, a monogermane ($GeH_4$) gas, and a digermane ($Ge_2H_6$) gas can be used. As the reactant gas, for example, an oxidizing gas of an oxygen (O)-containing gas can be used. As the oxidizing gas, for example, one or more of gases including oxygen ($O_2$), ozone ($O_3$), water vapor ($H_2O$), a mixed gas of $H_2$ and $O_2$, hydrogen peroxide ($H_2O_2$), and nitrous oxide ($N_2O$) can be used. As the nitriding gas, for example, one or more of hydrogen nitride-based gases such as an ammonia ($NH_3$) gas, a diazene ($N_2H_2$) gas, a hydrazine ($N_2H_4$) gas, and an $N_3H_8$ gas can be used. As the sulfurizing gas, for example, a gas containing sulfane ($H_2S$), disulfane ($H_2S_2$), diammonium sulfide (($NH_4)_2S$), dimethyl sulfide (($CH_3)_2S$), or the like can be used. As the sulfurizing gas, one or more of these gases can be used. As the selenizing gas, for example, a gas containing selane ($H_2Se$), diselane ($H_2Se_2$), dimethyl selenide (($CH_3)_2Se$), or the like can be used. As the selenizing gas, one or more of these gases can be used. As the tellurizing gas, for example, a gas containing tellane ($H_2Te$), ditellane ($H_2Te_2$), dimethyl telluride (($CH_3)_2Te$), or the like can be used. As the tellurizing gas, one or more of these gases can be used.

After the second layer 12 is formed on the surface of the wafer 200, the valve 243c is closed to stop supply of the reactant gas into the process chamber 201. Then, vacuum exhaust and purge in the process chamber 201 are performed in a similar procedure to that in the step b1.

[Execution of predetermined number of times]

By performing the first cycle including the above-described steps b1 and b2 a predetermined number of times (m times, m is 1 or an integer of 2 or more), the second layer 12 can be stacked on the surface of the wafer 200 to form a layer containing the second element, which is the second layer 12 having a desired film thickness.

For example, when the reactant gas is a reducing gas, a layer mainly containing the second element can be formed on the wafer 200. For example, when any one of an oxidizing gas, a nitriding gas, a sulfurizing gas, a selenizing gas, and a tellurizing gas is used as the reactant gas, an oxidized layer containing the second element, a nitrided layer containing the second element, a sulfurized layer containing the second element, a selenized layer containing the second element, or a tellurized layer containing the second element can be formed on the wafer 200. For example, when a Hf-containing gas is used as the second gas and an oxidizing gas is used as the reactant gas, an oxidized layer (HfO layer) containing hafnium can be formed on the wafer 200.

(Step a)

Next, the following steps a1, a2, a3, and a4 are sequentially executed on the wafer 200.

[Step a1]

Next, an inhibiting gas (inhibitor) is supplied to the wafer 200 on a surface of which the layer containing the second element (also referred to as the second layer 12 having a desired film thickness) is formed in the process chamber 201. Specifically, the valve 243d is opened to cause the inhibiting gas to flow into the gas supply pipe 232d. A flow rate of the inhibiting gas is regulated by the MFC 241d, and the inhibiting gas is supplied into the process chamber 201 and to the wafers 200 via the nozzle 249a and exhausted from the exhaust port 231a (inhibiting gas supply). At this time, the valves 243g to 243i may be opened to supply an inert gas into the process chamber 201 via the nozzles 249a to 249c, respectively.

Processing conditions when the inhibiting gas is supplied in this step are exemplified as follows:

processing pressure: 1 to 10,000 Pa, preferably, 10 to 1,333 Pa,
inhibiting gas supply flow rate: 0.001 to 2 slm, preferably, 0.01 to 1 slm, and
inhibiting gas supply time: 1 to 120 seconds, preferably, 1 to 60 seconds.

By this step, an inhibiting group 13 that inhibits adsorption of the first gas to the wafer 200 can be adsorbed to an adsorption site present on the surface of the wafer 200 on which the layer containing the second element is formed (see FIGS. 3C and 3D). Specifically, as a result, the inhibiting group 13 can be discontinuously adsorbed to at least a part of the surface of the wafer 200. At this time, the inhibiting group 13 is adsorbed preferentially to a portion where a gas is easily supplied than a portion where a gas is hardly supplied. Specifically, for example, the inhibiting group 13 is adsorbed preferentially to an end portion of the wafer 200 closer to a gas supply hole 250a than to a central portion of the wafer 200 farther from the gas supply hole 250a. Here, the inhibiting group 13 is formed by at least a part of a molecular structure of the inhibiting gas being adsorbed onto the wafer 200.

As the inhibiting gas, a halogen-containing gas containing at least one of Cl, F, Br, and I can be used. The halogen-containing gas has at least one of halogen groups such as a Cl group, an F group, a Br group, and an I group as a functional group. Examples of the inhibiting gas include a simple substance gas of a halogen element such as a fluorine ($F_2$) gas, a chlorine ($Cl_2$) gas, a bromine ($Br_2$) gas, or an iodine ($I_2$) gas, an interhalogen compound gas such as a chlorine fluoride ($ClF_3$) gas, a bromine chloride (BrCl) gas, an iodine chloride (ICl) gas, an iodine fluoride ($IF_5$) gas, a bromine fluoride ($BrF_3$) gas, or an iodine bromide (IBr) gas, a hydrogen halide compound gas such as a hydrogen chloride (HCl) gas, a hydrogen fluoride (HF) gas, a hydrogen bromide (HBr) gas, or a hydrogen iodide (HI) gas, and a gas obtained by combining these gases.

In addition, as the inhibiting gas, a gas containing an organic functional group can be used, and a gas containing an organic compound can be used. As the gas containing an organic compound, a gas containing at least one selected from the group consisting of an ether compound, a ketone compound, an amine compound, an organic hydrazine compound, and a compound having a cyclic structure in a molecular structure thereof can be used. As the gas containing an ether compound, a gas containing at least one of dimethyl ether, diethyl ether, methyl ethyl ether, propyl ether, isopropyl ether, furan, tetrahydrofuran, pyran, tetrahydropyran, and the like can be used. As the gas containing a ketone compound, a gas containing at least one of dimethyl ketone, diethyl ketone, methyl ethyl ketone, methyl propyl ketone, and the like can be used. As the gas containing an amine compound, a gas containing at least one of a methylamine compound such as monomethylamine, dimethylamine, or trimethylamine, an ethylamine compound such as monoethylamine, diethylamine, or triethylamine, and a methylethylamine compound such as dimethylethylamine or methyldiethylamine can be used. As the gas containing an organic hydrazine compound, a gas containing at least one of methylhydrazine-based gases such as monomethylhydrazine, dimethylhydrazine, and trimethylhydrazine can be used. As the gas containing a compound having a cyclic structure, a gas having a cyclic structure containing at least one of a cycloalkyl group, a benzene ring structure, and carbon in a molecular structure thereof, such as methoxycyclopentane, anisole, or trimethylene oxide can be used. As the inhibiting gas, one or more of these gases can be used. An alkyl group-containing gas containing an alkyl group can also be used. As the inhibiting gas, a methane ($CH_4$) gas, an ethane ($C_2H_6$) gas, a propane ($C_3H_8$) gas, or the like can be used.

As the inhibiting gas, a gas containing no atom of the first element contained in the first gas is preferably used. As a result, it is possible to further reduce an increase in the concentration of the first element at a portion where a gas is easily supplied, and thus it is possible to form a layer to which a smaller amount of the first element is uniformly added.

After the inhibiting group 13 is adsorbed to the surface of the wafer 200, the valve 243d is closed to stop supply of the inhibiting gas into the process chamber 201. Then, vacuum exhaust and purge in the process chamber 201 are performed in a similar procedure to that in the step b1.

[Step a2]

After start of the step a1, a promoting gas is supplied to the wafer 200 to a surface of which the inhibiting group 13 is adsorbed in the process chamber 201. Specifically, the valve 243e is opened to cause the promoting gas to flow into the gas supply pipe 232e. A flow rate of the promoting gas is regulated by the MFC 241e, and the promoting gas is supplied into the process chamber 201 and to the wafers 200 via the nozzle 249b and exhausted from the exhaust port 231a (promoting gas supply). At this time, the valves 243g to 243i may be opened to supply an inert gas into the process chamber 201 via the nozzles 249a to 249c, respectively.

Processing conditions when the promoting gas is supplied in this step are exemplified as follows:

processing pressure: 1 to 10,000 Pa, preferably, 10 to 1,333 Pa,
promoting gas supply flow rate: 1 to 30 slm, preferably, 2 to 20 slm, and
promoting gas supply time: 1 to 120 seconds, preferably, 1 to 30 seconds.

By this step, the promoting group 14 can be adsorbed to at least a part of the surface of the wafer 200. At this time, formation of the promoting group 14 by the promoting gas is inhibited by the inhibiting group 13. Therefore, the promoting group 14 that promotes adsorption of the first gas to the wafer 200 can be adsorbed to an adsorption site to which the inhibiting group 13 is not adsorbed on the surface of the wafer 200. That is, the promoting group 14 can be adsorbed to a gap between the inhibiting groups 13 (see FIGS. 3E and 3F). As a result, it is possible to suppress an increase in the adsorption amount of the first gas at a portion where a gas is easily supplied.

In addition, in this step, by supplying a sufficient amount of the promoting gas with respect to the surface area of the wafer 200, it is possible to form a relatively large number of the promoting groups 14 at a portion where the inhibiting group 13 is hardly formed and a gas is hardly supplied. Specifically, for example, the promoting group 14 is adsorbed preferentially to a central portion of the wafer 200 farther from a gas supply hole 250b than to an end portion of the wafer 200 closer to the gas supply hole 250b. Therefore, the promoting gas is preferably supplied until a reaction with the surface of the wafer 200 is saturated such that the promoting group is sufficiently formed even at a portion where a gas is hardly supplied.

The promoting group 14 is preferably formed by at least a part of a molecular structure of the promoting gas being adsorbed to a region where the inhibiting group 13 is not formed on the wafer 200. In this case, the first gas can be easily adsorbed to a region between the inhibiting groups 13.

Note that it is preferable to set gases used as the promoting gas and the inhibiting gas such that a molecular size of the promoting gas is smaller than that of the inhibiting gas. That is, a molecular radius of the promoting gas is preferably smaller than that of the inhibiting gas. As a result, the first gas is easily adsorbed by the promoting group 14 being adsorbed to a region between the inhibiting groups 13.

As the promoting gas, for example, a gas containing two or more O-H bonds in a molecular structure thereof or a gas containing two or more N-H bonds in a molecular structure thereof can be used. As the gas containing two or more O-H bonds in a molecular structure thereof, for example, a gas containing $H_2O$, $H_2O_2$, or the like can be used. As the gas containing two or more N-H bonds in a molecular structure thereof, for example, a gas containing $NH_3$ or the like can be used.

After the promoting group is formed on the surface of the wafer 200, the valve 243e is closed to stop supply of the promoting gas into the process chamber 201. Then, vacuum exhaust and purge in the process chamber 201 are performed in a similar procedure to that in the step b1.

[Step a3]

After start of the step a2, the first gas (dopant) is supplied to the wafer 200 to a surface of which the inhibiting group 13 and the promoting group 14 are adsorbed in the process chamber 201. Specifically, the valve 243a is opened to cause the first gas to flow into the gas supply pipe 232a. A flow rate of the first gas is regulated by the MFC 241a, and the first gas is supplied into the process chamber 201 and to the wafers 200 via the nozzle 249a and exhausted from the exhaust port 231a (first gas supply). At this time, the valves 243g to 243i may be opened to supply an inert gas into the process chamber 201 via the nozzles 249a to 249c, respectively.

Processing conditions when the first gas is supplied in this step are exemplified as follows:

processing pressure: 1 to 10,000 Pa, preferably, 10 to 1,333 Pa,
first gas supply flow rate: 0.01 to 3 slm, preferably, 0.1 to 2 slm, and
first gas supply time: 1 to 120 seconds, preferably, 1 to 60 seconds.

As the first gas, a gas containing the first element can be used. By this step, at least a part of the first gas can be physically or chemically adsorbed to a portion where the inhibiting group 13 is not adsorbed and the promoting group 14 is adsorbed on the surface of the wafer 200. That is, an atom 15 of the first element is easily adsorbed to a gap between the inhibiting groups 13 (see FIG. 3G).

Here, when a gas is supplied from an end side of the wafer 200, the gas is easily adsorbed on the end side of the wafer 200 closer to the gas supply holes 250a to 250c, and the gas is hardly adsorbed on a central side of the wafer 200 farther from the gas supply holes 250a to 250c. In the present embodiment, by supplying the inhibiting gas that inhibits adsorption of the first gas before the first gas is supplied to the wafer 200, more inhibiting groups 13 are adsorbed to the end side of the wafer 200 where a gas is easily adsorbed than to the central side. Thereafter, by supplying the promoting gas that promotes adsorption of the first gas until saturation, the promoting group 14 is adsorbed to a gap between the inhibiting groups 13. At this time, more promoting groups 14 are adsorbed to the central side of the wafer 200 having less inhibiting groups 13 than to the end side. Thereafter, by supplying the first gas, the atom 15 of the first element can be adsorbed up to the central side of the wafer 200 having more promoting groups 14 to form a third layer 16.

As the first element, for example, one or more of the elements exemplified as the second element can be used. As the first gas, for example, one or more of the gases exemplified as the second element can be used. As described above, when a layer containing the first element and the second element to which a small amount of the first element is added (doped) is formed on the wafer 200, it is preferable to use a gas containing no second element as the first element.

After the third layer 16 is formed on the surface of the wafer 200, the valve 243a is closed to stop supply of the first gas into the process chamber 201. Then, vacuum exhaust and purge in the process chamber 201 are performed in a similar procedure to that in the step b1.

[Step a4]

After start of the step a3, a removal gas is supplied to the wafer 200 on a surface of which the third layer 16 is formed in the process chamber 201. Specifically, the valve 243f is opened to cause the removal gas to flow into the gas supply pipe 232c. A flow rate of the removal gas is regulated by the MFC 241f, and the removal gas is supplied into the process chamber 201 and to the wafers 200 via the nozzle 249c and exhausted from the exhaust port 231a (removal gas supply). At this time, the valves 243g to 243i may be opened to supply an inert gas into the process chamber 201 via the nozzles 249a to 249c, respectively.

Processing conditions when the removal gas is supplied in this step are exemplified as follows:

processing pressure: 1 to 10,000 Pa, preferably, 10 to 1,333 Pa,
removal gas supply flow rate: 1 to 30 slm, preferably, 2 to 20 slm, and
removal gas supply time: 1 to 120 seconds, preferably, 1 to 30 seconds.

By this step, at least some of the inhibiting groups 13 on the surface of the wafer 200 can be removed, and the third layer 16 containing the atom 15 of the first element can be modified to a fourth layer 17 (see FIG. 3H). This can make it difficult for a layer 19 containing the first element and the second element to contain a component derived from the inhibiting group 13. In addition, in the next step b1, physical or chemical adsorption of the second gas to the wafer 200 can be promoted. In addition, this step is preferably performed until a reaction between the removal gas and the surface of the wafer 200 is saturated. This can make it further difficult for the layer 19 to contain a component derived from the inhibiting group 13, and can promote physical or chemical adsorption of the second gas to the wafer 200. As the removal gas, for example, an oxidizing gas or a nitriding gas as described above can be used.

As the removal gas, a gas that more easily removes the inhibiting group 13 from the wafer 200 than the promoting gas in the above-described step a2 is used. This can make it difficult for the inhibiting group 13 to be removed by the promoting gas, and therefore can make it easy for the first gas to be easily adsorbed to a region between the inhibiting groups 13. In addition, this can make it easy for the inhibiting group 13 to be removed by the removal gas, and therefore can make it difficult for the layer 19 containing the first element and the second element to contain a component derived from the inhibiting group 13. In addition, in the next step b1, physical or chemical adsorption of the second gas can be further promoted.

For example, a first oxidizing gas can be used as the removal gas, and a second oxidizing gas different from the first oxidizing gas can be used as the reactant gas. For example, when $O_3$ is used as the second oxidizing gas, a mixed gas of $O_2$, $H_2O$, $H_2$, and $O_2$ can be used as the first oxidizing gas. A nitriding gas can be used as the removal gas, and an oxidizing gas can be used as the reactant gas. For example, when a mixed gas of $O_2$, $H_2O$, $H_2$, and $O_2$ is used as the oxidizing gas, $NH_3$ can be used as the nitriding gas. A first nitriding gas can be used as the removal gas, and a second nitriding gas different from the first nitriding gas can be used as the reactant gas. For example, when $NH_3$ is used as the second nitriding gas, $N_2H_4$ can be used as the first nitriding gas.

By performing steps a2 and a4 under the above-described processing conditions, the exposure amount of the removal gas to the wafer 200 in the step a4 can be larger than the exposure amount of the promoting gas to the wafer 200 in the step a2. As a result, in the step a2, the inhibiting group 13 can be hardly removed by the promoting gas, and in the step a4, the inhibiting group 13 can be easily removed by the removal gas. This can make it difficult for the layer 19 containing the first element and the second element to contain a component derived from the inhibiting group 13. In addition, in the next step b1, physical or chemical adsorption of the second gas can be further promoted.

In the present specification, the "exposure amount of a gas" refers to a value obtained by time-integrating a partial pressure of a gas, and can be obtained as a product of a partial pressure of a gas and a supply time of the gas when the partial pressure of the gas can be regarded as constant.

Here, a supply time of the removal gas in this step is preferably longer than a supply time of the promoting gas in the step a2. A processing pressure in this step is preferably higher than a processing pressure in the step a2. A removal gas supply flow rate in this step is preferably larger than a promoting gas supply flow rate in the step a2. An inert gas supply flow rate in this step is preferably smaller than an inert gas supply flow rate in the step a2. A partial pressure of the removal gas in this step is preferably higher than a partial pressure of the promoting gas in the step a2. A molar fraction of the removal gas in this step is preferably larger than a molar fraction of the promoting gas in the step a2. By one or more of these, the exposure amount of the removal gas to the wafer 200 in the step a4 can be larger than the exposure amount of the promoting gas to the wafer 200 in the step a2.

After the reaction between the surface of the wafer 200 and the removal gas is saturated to form the fourth layer 17, the valve 243f is closed to stop supply of the removal gas into the process chamber 201. Then, vacuum exhaust and purge in the process chamber 201 are performed in a similar procedure to that in the step b1.

[Execution of predetermined number of times]

By performing the second cycle in which the above-described steps a1 to a4 are performed in this order n times (n is 1 or an integer of 2 or more), the fourth layer 17 can be stacked on the surface of the wafer 200 to form a layer containing the first element, which is the fourth layer 17 having a desired film thickness.

For example, when the removal gas is an oxidizing gas, an oxidized layer containing the first element can be formed on the wafer 200. For example, when an Al-containing gas is used as the first gas and an oxidizing gas is used as the removal gas, an oxidized layer (AlO layer) containing aluminum can be formed on the wafer 200.

[Execution of predetermined number of times]

Then, the step b of performing the first cycle in which the steps b1 and b2 are performed in this order m times and the step a of performing the second cycle in which the above-described steps a1 to a4 are performed in this order n times are performed a predetermined number of times (p times, p is 1 or an integer of 2 or more). As a result, a fifth layer 18 in which at least a part of the second gas is physically or chemically adsorbed to the fourth layer 17 and the layer 19 containing the first element and the second element are formed on the surface of the wafer 200 (see FIGS. 3I and 3J).

As a result, it is possible to reduce a difference in the adsorption amount of the atoms 15 of the first element between a portion where the first gas is easily supplied and a portion where the first gas is hardly supplied while suppressing an increase in the concentration of the first element in the layer 19 containing the first element and the second element. Therefore, the layer 19 containing the second element to which a small amount of the first element is uniformly added, that is, a homogeneous film can be formed on the wafer 200.

For example, when an Al-containing gas is used as the first gas, an oxidizing gas is used as the removal gas, a Hf-containing gas is used as the second gas, and an oxidizing gas is used as the reactant gas, a hafnium oxidized layer (HfO layer) to which a small amount of Al is added (doped) can be formed on the wafer 200.

(After-Purge and Atmospheric Pressure Restoration)

After the film forming processing is completed, the inside of the process chamber 201 is purged in a similar procedure to that in the step b1 (after-purge). Thereafter, an atmosphere in the process chamber 201 is replaced with an inert gas (inert gas replacement), and a pressure in the process chamber 201 is restored to a normal pressure (atmospheric pressure restoration).

(Boat Unload and Wafer Discharge)

The seal cap 219 is lowered by the boat elevator 115, a lower end of the manifold 209 is opened, and the boat 217 is unloaded to the outside of the reaction tube 203 (boat unload). Thereafter, the shutter 219s is moved, and a lower end opening of the manifold 209 is sealed with the shutter 219s via the O-ring 220c (shutter close). After being unloaded to the outside of the reaction tube 203, the processed wafer 200 is taken out from the boat 217 (wafer discharge).

<Other embodiment of present disclosure>

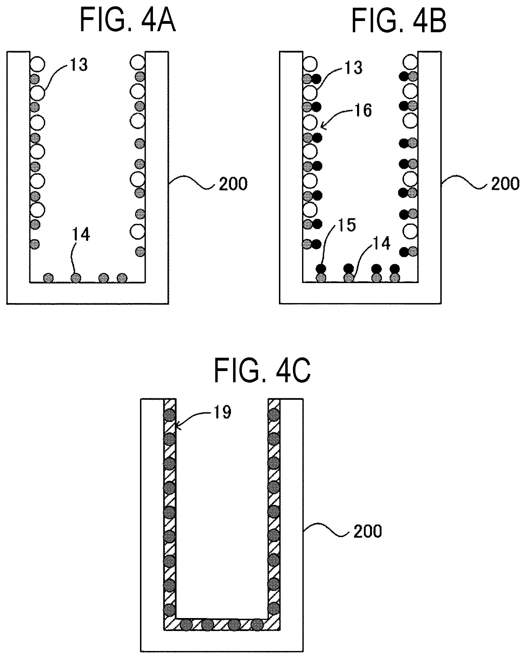

Next, a case where a recess such as a trench, a groove, or a hole having a three-dimensional structure is formed on a surface of the wafer 200, and the layer 19 containing the first element and the second element described above, that is, the layer 19 containing the second element to which a small amount of the first element is added is formed in the recess will be described with reference to FIGS. 4A to 4C.

As described above, when the layer 19 containing the second element to which a small amount of the first element is added is formed in the recess of the wafer 200, the first gas is easily supplied to an opening side and is hardly supplied to a deep side. Therefore, the concentration of the first element is high on the opening side of the recess, and the concentration of the first element is low on the deep side of the recess.

The inhibiting group 13 is adsorbed in the recess of the wafer 200 by the procedure of the above-described step a1. At this time, since the inhibiting gas is easily supplied to the opening side of the recess, the inhibiting group 13 is easily formed on the opening side, and since the inhibiting gas is hardly supplied to the deep side of the recess, the inhibiting group 13 is hardly formed on the deep side. That is, the inhibiting group 13 is preferentially adsorbed to the opening side of the recess rather than the deep side of the recess.

Next, the promoting group 14 is adsorbed in the recess of the wafer 200 by the procedure of the above-described step a2. At this time, although the promoting gas is easily supplied to the opening side of the recess, adsorption of the promoting group 14 is inhibited by the inhibiting group 13 formed on the opening side, and although the promoting gas is hardly supplied to the deep side of the recess, the promoting gas is supplied to the deep side until the reaction is saturated, and therefore adsorption of the promoting group 14 is hardly inhibited (see FIG. 4A). That is, the promoting group 14 is hardly adsorbed to the opening side of the recess and is easily adsorbed to the deep side of the recess. That is, the promoting group 14 is preferentially adsorbed to the deep side of the recess rather than the opening side of the recess.

Next, the third layer 16 is formed by causing at least a part of the first gas to be physically or chemically adsorbed in the recess of the wafer 200 by the procedure of the above-described step a3. At this time, physical or chemical adsorption of the first gas is inhibited on the opening side of the recess by the inhibiting group 13 formed on the opening side, and physical or chemical adsorption of the first gas is promoted on the deep side of the recess by the promoting group 14 formed on the deep side (see FIG. 4B).

Next, at least some of the inhibiting groups 13 in the recess are removed by the procedure of above-described step a4, and the third layer 16 is modified. Then, by performing, a predetermined number of times, the step a of performing the above-described steps a1 to a4 a predetermined number of times and the step b of performing the above-described steps b1 and b2 a predetermined number of times, the layer 19 containing the second element to which a small amount of the first element is uniformly added is formed in the recess of the wafer 200 (FIG. 4C).

Also in the present embodiment, effects similar to those in the above-described embodiment can be obtained. That is, since the concentration of the first element on the opening side of the recess to which a gas is easily supplied can be reduced, the layer 19 containing the second element to which a small amount of the first element is uniformly added (doped) can be formed on the surface of the wafer 200. In the present embodiment, it is also possible to reduce a concentration difference of the first element in the layer containing the first element and the second element between the opening side and the deep side of the recess. That is, a homogeneous film can be formed on the wafer 200.

The embodiments of the present disclosure have been specifically described above. However, the present disclosure is not limited to the above-described embodiments, and can be variously modified without departing from the gist thereof.

Preferably, a recipe used in each piece of processing is individually prepared according to processing contents and is recorded and stored in the memory 121c via an electric communication line or the external memory 123. Then, when each piece of processing is started, the CPU 121a preferably appropriately selects an appropriate recipe from among the plurality of recipes recorded and stored in the memory 121c according to the processing contents. As a result, it is possible to form films having various film types, composition ratios, film qualities, and film thicknesses with favorable reproducibility by using one substrate processing apparatus. In addition, it is possible to reduce a burden on an operator, and it is possible to start each piece of processing quickly while avoiding an operation error.

The recipe described above is not limited to a newly created recipe, but may be prepared by, for example, changing an existing recipe already installed in the substrate processing apparatus. In the case of changing the recipe, the changed recipe may be installed in the substrate processing apparatus via a telecommunication line or a recording medium in which the recipe is recorded. The existing recipe already installed in the substrate processing apparatus may be directly changed by operation of the input/output device 122 included in the existing substrate processing apparatus.

In the above-described embodiments, an example has been described in which a layer is formed by use of a batch-type substrate processing apparatus that processes a plurality of substrates at a time. The present disclosure is not limited to the above-described embodiments, and can be appropriately applied to a case where a layer is formed by use of a single wafer type substrate processing apparatus that processes one or several substrates at a time, for example. In the above-described embodiments, an example has been described in which a layer is formed by use of a substrate processing apparatus including a hot wall type processing furnace. The present disclosure is not limited to the above-described embodiments, and is suitably applicable to a case where a layer is formed by use of a substrate processing apparatus including a cold wall type processing furnace. In addition, in the above-described embodiments, an example in which a gas is activated by heat has been described. However, the present disclosure is not limited thereto. For example, the present disclosure can also be suitably applied to a case where a gas is activated by plasma generated inside or outside the process chamber 201, and a case where a gas is activated by irradiating the gas with electromagnetic waves by a lamp or the like.

Also in cases where these substrate processing apparatuses are used, each piece of processing can be performed in accordance with processing procedures and processing conditions similar to those in the above-described embodiments, and effects similar to those in the above-described embodiments can be obtained.

In the above description, the processing sequence of forming a layer containing the first element and the second element to which a small amount of the first element is added (doped) on the wafer 200 has been exemplified. However, the present disclosure is not limited thereto. For example, even when a gas containing, as the second element, the same element as the first element is used as the second gas, a similar effect to that described above can be obtained. In this case, since the first element adsorbed onto the wafer 200 can be made uniform, a layer (or film) having a uniform thickness can be formed on the surface of the wafer 200, that is, a homogeneous film can be formed.

The above-described embodiments can be used in combination as appropriate. Processing procedures and processing conditions at this time can be similar to the processing procedures and the processing conditions in the embodiments described above, for example.

According to the present disclosure, a homogeneous layer (or film) can be formed on a substrate.

**Claims**

1. A method of processing a substrate, comprising

   (a) forming a layer containing a first element on a substrate by performing:

      (a1) supplying an inhibiting gas to the substrate to form an inhibiting group on the substrate, wherein the inhibiting group inhibits adsorption of a first gas containing an atom of the first element to the substrate;
      (a2) supplying a promoting gas to the substrate after start of (a1) to form a promoting group on the substrate, wherein the promoting group promotes adsorption of the first gas to the substrate; and
      (a3) supplying the first gas to the substrate after start of (a2).

2. The method of claim 1, further comprising

   (b) forming a layer containing a second element on the substrate by performing a cycle a predetermined number of times, wherein the cycle including:

      (b1) supplying a second gas containing an atom of the second element different from the first element to the substrate; and
      (b2) supplying a reactant gas to the substrate,

   wherein a layer containing the first element and the second element is formed on the substrate by performing (a) and (b).

3. The method of claim 2, wherein (a) further includes,
   (a4) supplying a removal gas to the substrate after start of (a3) to remove at least some of the inhibiting groups on the substrate.

4. The method of claim 3, wherein an exposure amount of the removal gas to the substrate in (a4) is larger than an exposure amount of the promoting gas to the substrate in (a2).

5. The method of claim 3 or 4, wherein a gas that more easily removes the inhibiting group from the substrate than the promoting gas is used as the removal gas.

6. The method of any one of claims 3 to 5, wherein a first oxidizing gas is used as the removal gas, and a second oxidizing gas different from the first oxidizing gas is used as the reactant gas.

7. The method of any one of claims 3 to 6, wherein (a4) is performed until a reaction between the removal gas and a surface of the substrate is saturated.

8. The method of any one of claims 1 to 7, wherein (a2) is performed until a reaction between the promoting gas and a surface of the substrate is saturated.

9. The method of any one of claims 1 to 8, wherein the inhibiting gas does not contain an atom of the first element.

10. The method of any one of claims 1 to 9,

wherein the inhibiting group is formed by at least a part of a molecular structure of the inhibiting gas being adsorbed onto the substrate, and
wherein the promoting group is formed by at least a part of a molecular structure of the promoting gas being adsorbed to a region where the inhibiting group is not formed on the substrate.

11. The method of any one of claims 1 to 10, wherein gases used as the promoting gas and the inhibiting gas are set such that a molecular size of the promoting gas is smaller than a molecular size of the inhibiting gas.

12. The method of any one of claims 1 to 11, wherein the inhibiting gas is a gas containing an organic functional group.

13. A method of manufacturing a semiconductor device, comprising the method of clam 1.

14. A substrate processing apparatus comprising:

a gas supply system that supplies an inhibiting gas, a promoting gas, and a first gas containing an atom of a first element to a substrate; and
a controller capable of controlling the gas supply system to perform a process including

(a) forming a layer containing the first element on the substrate by performing:

(a1) supplying the inhibiting gas to the substrate to form an inhibiting group on the substrate, wherein the inhibiting group inhibits adsorption of the first gas to the substrate;
(a2) supplying the promoting gas to the substrate after start of (a1) to form a promoting group on the substrate, wherein the promoting group promotes adsorption of the first gas to the substrate; and
(a3) supplying the first gas to the substrate after start of (a2).

15. A program that causes, by a computer, a substrate processing apparatus to perform a process comprising

(a) forming a layer containing a first element on a substrate by performing:

(a1) supplying an inhibiting gas to the substrate to form an inhibiting group on the substrate, wherein the inhibiting group inhibits adsorption of a first gas containing an atom of the first element to the substrate;
(a2) supplying a promoting gas to the substrate after start of (a1) to form a promoting group on the substrate, wherein the promoting group promotes adsorption of the first gas to the substrate; and
(a3) supplying the first gas to the substrate after start of (a2).

# FIG. 1

## FIG. 2

## FIG. 3A

## FIG. 3B

17

FIG. 3C

13

200

FIG. 3D

13

FIG. 3E

13 14

200

FIG. 3F

13 14

FIG. 3G

16

13 15 14

200

FIG. 3H

17

200

FIG. 3I

18

200

FIG. 3J

19

200

# FIG. 4A

# FIG. 4B

# FIG. 4C

Europäisches
Patentamt
European
Patent Office
Office européen
des brevets

**EUROPEAN SEARCH REPORT**

Application Number

EP 25 22 3699

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/030026 A1 (MIYATA SHOMA [JP] ET AL) 25 January 2024 (2024-01-25) | 1,3-15 | INV.<br>C23C16/455<br>H10P14/60 |
| Y | * paragraphs [0056], [0057], [0058], [0063], [0069], [0073], [0075], [0076], [0077], [0128]; claim 22; figures 1, 4B, 4C, 4D *<br>* paragraphs [0095], [0120], [0131], [0177], [0178], [0211], [0239]; claim 20; figures 4E, 5E * | 2 | |
| Y | US 2024/287672 A1 (ISOBE NORIYUKI [JP] ET AL) 29 August 2024 (2024-08-29)<br>* paragraphs [0147], [0152]; figure 4 * | 2 | |
| A | US 2024/254625 A1 (NAKATANI KIMIHIKO [JP] ET AL) 1 August 2024 (2024-08-01)<br>* figure 10 * | 11 | |

TECHNICAL FIELDS
SEARCHED    (IPC)

C23C

The present search report has been drawn up for all claims

| Place of search | Date of completion of the search | Examiner |
|---|---|---|
| The Hague | 10 June 2026 | Mauchauffé, Rodolphe |

EPO FORM 1503 03.82 (P04C01)

## ANNEX TO THE EUROPEAN SEARCH REPORT
## ON EUROPEAN PATENT APPLICATION NO.

EP 25 22 3699

This annex lists the patent family members relating to the patent documents cited in the above-mentioned European search report.
The members are as contained in the European Patent Office EDP file on
The European Patent Office is in no way liable for these particulars which are merely given for the purpose of information.

10-06-2026

| Patent document cited in search report | Publication date | Patent family member(s) | Publication date |
|---|---|---|---|
| US 2024030026 A1 | 25-01-2024 | CN 117121172 A | 24-11-2023 |
| | | JP 7636543 B2 | 26-02-2025 |
| | | JP 7857455 B2 | 12-05-2026 |
| | | JP 2025072625 A | 09-05-2025 |
| | | JP WO2022264430 A1 | 22-12-2022 |
| | | KR 20240021740 A | 19-02-2024 |
| | | TW 202300685 A | 01-01-2023 |
| | | US 2024030026 A1 | 25-01-2024 |
| | | WO 2022264430 A1 | 22-12-2022 |
| US 2024287672 A1 | 29-08-2024 | CN 118553600 A | 27-08-2024 |
| | | EP 4435144 A2 | 25-09-2024 |
| | | JP 7791849 B2 | 24-12-2025 |
| | | JP 2024120709 A | 05-09-2024 |
| | | KR 20240131890 A | 02-09-2024 |
| | | TW 202436679 A | 16-09-2024 |
| | | US 2024287672 A1 | 29-08-2024 |
| US 2024254625 A1 | 01-08-2024 | CN 117882176 A | 12-04-2024 |
| | | JP 7688716 B2 | 04-06-2025 |
| | | JP WO2023047918 A1 | 30-03-2023 |
| | | KR 20240046217 A | 08-04-2024 |
| | | TW 202323562 A | 16-06-2023 |
| | | US 2024254625 A1 | 01-08-2024 |
| | | WO 2023047918 A1 | 30-03-2023 |

EPO FORM P0459

For more details about this annex : see Official Journal of the European Patent Office, No. 12/82

**EP 4 786 634 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2025013308 A